# EUROPEAN PATENT APPLICATION

(11) **EP 1 666 995 A2**
(43) Date of publication of application: **07.06.2006**
(21) Application number: 05257221.1
(22) Date of filing: 23.11.2005
(51) Int. Cl.: G04G 5/00, G04C 9/02

(54) **Radio controlled timepiece**

(30) Priority: 25.11.2004 JP 2004340356; 28.10.2005 JP 2005314050
(71) Applicant: SEIKO INSTRUMENTS INC., Chiba-shi, Chiba (JP)
(72) Inventor: Saitoh, Yoritaka, Chiba-shi Chiba (JP)
(74) Representative: Sturt, Clifford Mark

(57) **Abstract**

A reception means extracts a time code from a radio signal received by an antenna, thereby outputting it to a control means. The control means obtains an information of a present time instant from the time code extracted by the reception means and corrects a present time instant being clocked by its own clock means. A display means displays the present time instant being clocked by the clock means. In a case where there has been judged that the time code is not outputted from the reception means, the control means controls so as to alter a tuning frequency by altering a capacity value of a variable capacity diode.

## Description

The present invention relates to a radio-corrected timepiece in which a time instant is corrected on the basis of a time instant information received through radio wave.

From old times, there has been developed the radio-corrected timepiece in which the time instant is automatically corrected by receiving a radio signal representing an accurate time instant.

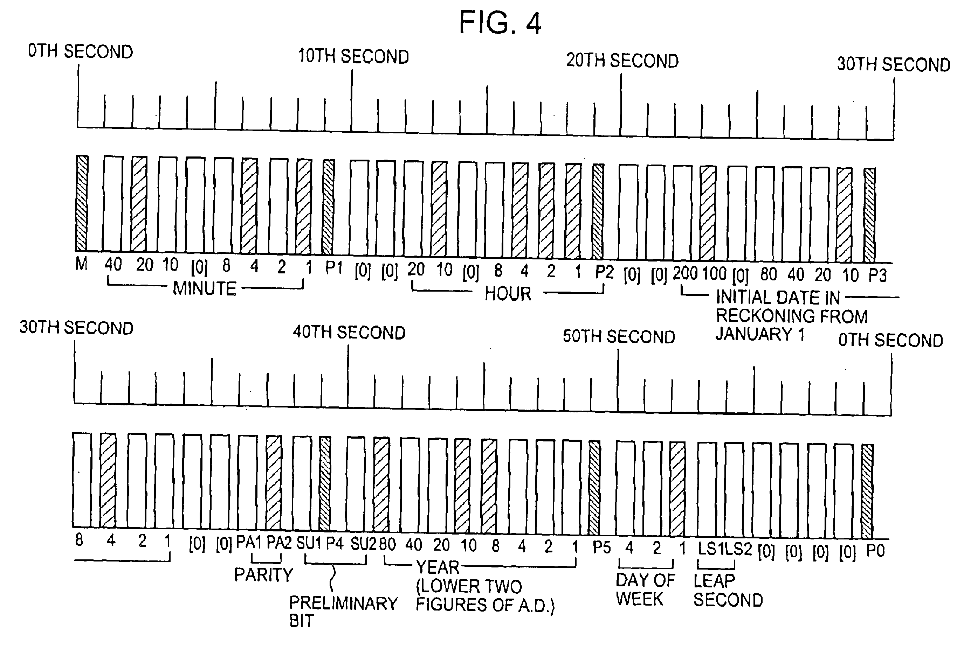

At present, in each state (for example, Germany, Japan, America, Britain, or the like), there is sent out a long wave standard wave, in which a time instant information has been superposed, from a radio station provided in a predetermined place. In Japan, the long wave standard waves of 40 kHz and 60 kHz respectively having been amplitude-modulated by a time code of a format like Fig. 4 are transmitted from two transmitting stations.

There is commercialized the radio-corrected timepiece which receives this long wave standard wave, and in which a time instant data of a clock circuit is corrected. In a case of such a radio-corrected timepiece, in order to receive the standard wave, there are possessed an antenna and a tuning circuit.

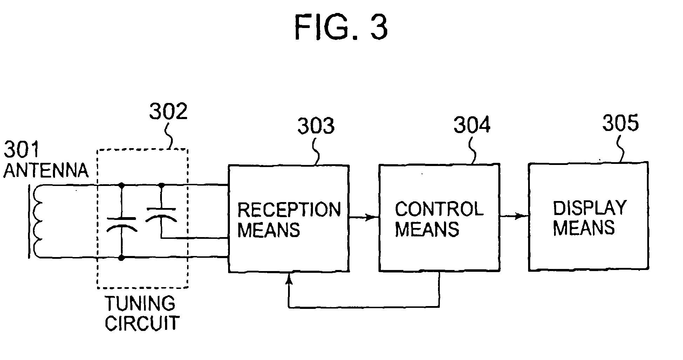

Fig. 3 is a block diagram of a conventional radio-corrected timepiece containing the tuning circuit. In Fig.3, 301 is an antenna, and it catches the radio signal and generates a reception signal. 302 is the tuning circuit, and capacitors are connected in parallel therein. And, by an inductance value of the antenna 301 and a capacity value of the tuning circuit 302, there is tuned to a reception frequency 40 kHz for instance. A signal, from an antenna circuit, tuned to 40 kHz is inputted to a reception means 303 and the time code containing an information of a present time instant is outputted.

By a time instant format recognitionmeans self-contained in a control means 304, the present time instant information is taken out and, by the accurate present time instant information concerned, a present time instant of a clock means which is provided in the control means 304 and clocks a time instant is corrected, thereby displaying a time instant (in this case, an accurate time instant after the correction), which is being clocked by the clock means, by a display means 305.

Incidentally, by performing an ON/OFF control of the reception means 303, the control means 304 performs an ON/OFF control of a reception operation of a standard wave signal.

Further, in recent years, as to the radio-corrected timepiece which can receive, in Japan and Germany, the long wave standard wave for instance, JJY of Japan is 40 kHz, 60 kHz and DCF of Germany 77.5 kHz and, in order to be tuned to each of the frequencies, there is adopted a method of switching the frequency by connecting the capacitor by plural pieces (refer to JP-A-2002-82187 Gazette).

In the above constitution, as to an adjustment of a reception sensitivity of the tuning circuit, there has been adopted such a method that as the capacitors used in the tuning circuit there are prepared ones of several kinds, and a capacity of the capacitor is decided while being coincided with each inductance of a bar antenna.

In the above reception sensitivity adjustment method, as to a method of exchanging the capacity of the capacitor, since the adjustment is performed by combining the plural capacitors, an assembly work of the radio-corrected timepiece becomes troublesome, so that there is an issue that a working efficiency is bad because a long time is required for the above adjustment.

Further, since the bar antenna is comparatively small in size and has a high Q value, only by a temperature change and a slight change in element such as a case where a metal adjacently exists, a tuning frequency greatly changes. For this reason, in the above reception sensitivity adjustment method, even if once adjusted to a tuning state, a possibility becoming a non-tuning state after having been handed to hands of a user is high, so that there is an issue that the reception sensitivity becomes deteriorated.

The present invention is one made in order to solve the above issues, and its problem is to make so as to be capable of being easily tuned to a standard wave signal.

Further, a problem of the present invention is to make so as to be capable of being tuned to plural standard wave signals whose frequencies are different.

Further, a problem of the present invention is to make such that the assembly work is simply performed.

According to the present invention, there is provided a radio-corrected timepiece characterized by comprising while possessing an antenna for receiving a radio signal containing a time code having an information of a present time instant, a tuning means having a variable capacity means and outputting a signal corresponding to the radio signal received by the antenna, a reception means extracting the time code from a signal outputted from the tuning means, a time instant correction means which obtains an information of the present time instant from the time code extracted by the reception means to thereby correct a present time instant being clocked by its own clock means, a display means displaying the present time instant being clocked by the clock means, and a control means which, in a case where there has been judged that the time code is not outputted from the reception means, controls so as to alter a tuning frequency of the tuning means by altering a capacity value of the variable capacity means.

The tuning means having the variable capacity means outputs the signal corresponding to the radio signal received by the antenna. The reception means extracts the time code from the signal outputted from the tuning means. The time instant correction means obtains the information of the present time instant from the time code extracted by the reception means to thereby correct the present time instant being clocked by its own clock means. The display means displays the present time instant being clocked by the clock means. In the case
where there has been judged that the time code is not outputted from the reception means, the control means controls so as to alter the tuning frequency of the tuning means by altering the capacity value of the variable capacity means.

Here, there may be constituted such that the reception means has a filter means causing plural frequency signals to selectively pass through, and a detection means extracting the time code having passed through the filter means to thereby output it, and, in a case where even if the alteration of the capacity value of the variable capacity means is performed by a predetermined number of times there has been judged that time code is not outputted from the reception means, the control means controls the filter means so as to alter a frequency passing through the filter means.

Further, there may be constituted such that it has a storage means for storing the capacity value of the variable capacity means when the reception of the time code has been successful, and, in a case where even if the capacity value of the variable capacity means is altered by a predetermined number of times there has been judged that the time code is not obtained, the control means terminates a reception operation of the reception means, and sets the capacity value of the variable capacity means to the capacity value of the last time in which a reception of the time code stored in the storage means has been successful, thereby terminating a time instant correction processing.

Further, there may be constituted such that, in a case where the time code has been received and a time instant correction processing has been performed, the control means stores the capacity value of the variable capacity means at that time to the storage means and, on the occasion of the time instant correction processing in a next time, controls the capacity value stored to the storage means so as to make it an initial value of the variable capacity means.

Further, there may be constituted such that the control means controls the variable capacity means so as to perform a reception operation by using the capacity value of the variable capacity means having been being used when the time code could be continuously received by a predetermined number of times.

Further, there may be constituted such that the variable capacity means is constituted by a variable capacity diode.

Further, there may be constituted such that the variable capacity means possesses a rough adjustment section having plural roughly adjusting capacitors whose capacity values are mutually different, and a fine adjustment section having finely adjusting capacitors whose capacity values are smaller than the roughly adjusting capacitors, and the control means alters the capacity value of the variable capacity means by combining the roughly adjusting capacitors and the finely adjusting capacitors.

Further, there may be constituted such that each of the roughly adjusting capacitors comprises while being selected to the capacity value corresponding to a reception frequency, and the control means finely adjusts a deviation of the tuning frequency when the roughly adjusting capacitors have been used from the reception frequency by using the finely adjusting capacitors.

Further, there may be constituted such that the fine adjustment section comprises with the plural finely adjusting capacitors being contained, and the control means alters the capacity value of the variable capacity means by selecting a combination of the capacitors contained in the rough adjustment section and the fine adjustment section.

Further, there may be constituted such that the finely adjusting capacitor contained in the fine adjustment section comprises while being constituted by a variable capacity diode, and the control means selects the capacitor in the rough adjustment section and alters the capacity value of the variable capacity means by altering the capacity value of the variable capacity diode.

Further, there may be constituted such that, in a case where an edge of a received digital signal could be continuously detected by a predetermined number of times, the control means judges that the time code has been received.

Further, there may be constituted such that it has an operation means for instructing an tuning operation, and the control means responds to an instruction of the tuning operation by the operation means to thereby alter the capacity value of the variable capacity means so as to be tuned to the radio signal.

Further, there may be constituted such that, additionally at a predetermined time previously decided or at a reset time, the control means alters the capacity value of the variable capacity means so as to be tuned to the radio signal.

Embodiments of the invention will now be described by way of further example only and with reference to the accompanying drawings, in which:
Fig.1 is a block diagram of a radio-corrected timepiece concerned with an embodiment of the present invention;
Fig.2 is a flowchart showing processings in the radio-corrected timepiece concerned with the embodiment of the present invention;
Fig. 3 is a block diagram of a conventional radio-corrected timepiece;
Fig. 4 is a diagram showing time codes of a standard wave used in Japan;
Fig.5 is a block diagram of the radio-corrected timepiece concerned with other embodiment of the present invention;
Fig.6 is a circuit diagram showing a constitution of a tuning means used in other embodiment of the present invention; and
Fig.7 is a flowchart showing processings in the radio-corrected timepiece concerned with other embodiment of the present invention.

Hereunder, it is explained about a radio-corrected time piece concerned with an embodiment of the present invention.

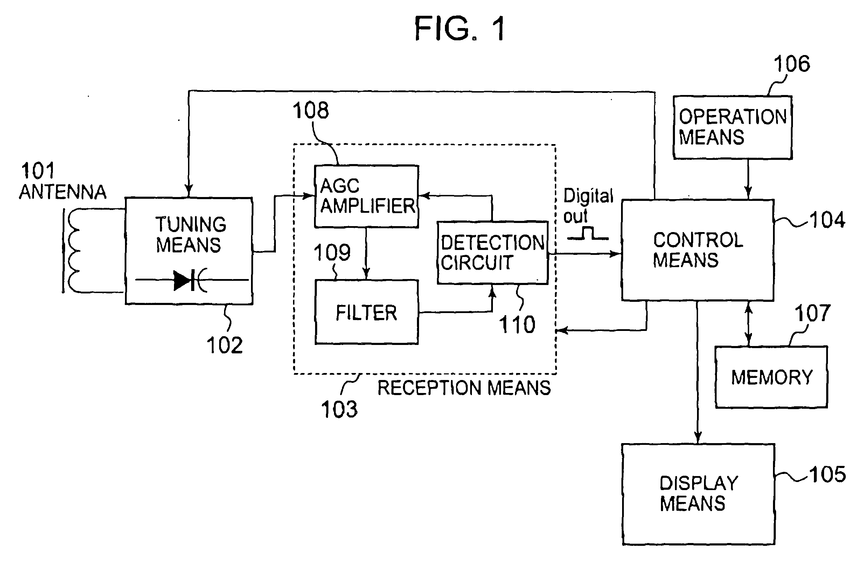

Fig. 1 is a block diagram of the radio-corrected timepiece concerned with the embodiment of the present invention, and is an example of the radio-corrected timepiece in which a time instant correction is performed by using a standard wave signal of Japan shown in Fig.4.

In Fig.1, the radio-corrected timepiece has an antenna 101 constituted by an antenna coil, a tuning means 102 having a variable capacity diode (variable cap) as a variable capacity means for altering a tuning frequency, a reception means 103, a control means 104 constituted by a central processing unit (CPU) and performing a control and the like of each constitutional element and the whole of the radio-corrected timepiece, a display means 105 constituted by a liquid crystal display and the like and displaying a present time instant and the like, an operation means 106 constituted by an operation switch and the like and for performing an instruction of a time instant correction processing, an instruction of a tuning operation, and the like, and a semiconductor memory 107 as a storage means for storing a program that the control means 104 implements, a capacity value of the variable capacity diode 102, and the like.

Incidentally, the control means 104 has also functions as a time instant correction means and a clock means. Further, since an alteration of a tuning frequency of the tuning means is performed by altering the capacity value of the variable capacity diode, for convenience' sake, the explanation is made with the reference numeral 102 being applied to the variable capacity diode.

The reception means 103 has an AGC amplifier 108 for amplifying a signal from the variable capacity diode 102, a filter 109 as a filter means for causing a signal of a predetermined frequency in an output signal of the AGC amplifier 108 to pass through, and a detection circuit 110 as a detection means for extracting a time code contained in the standard wave signal received by the antenna 101 by detecting an output signal of the filter 109 to thereby output it to the control means 104.

The filter 109 has in its inside plural quartz oscillators and, by switch-selecting the quartz oscillators by the control of the control means 104, selects any in plural frequency signals, thereby causing it to pass through. Further, the detection circuit 110 extracts the time code from a signal having passed through the filter 109 to thereby output it to the control means 104, and controls a gain of the AGC amplifier 108.

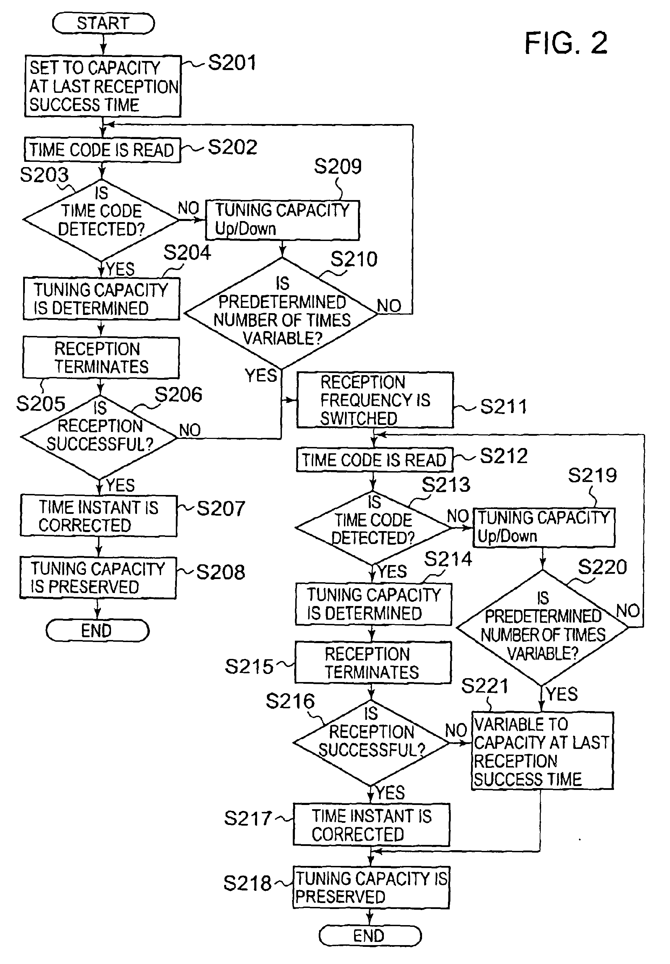

Fig.2 is a flowchart showing processings in the radio-corrected timepiece of Fig.1, and shows mainly the processings performed by the fact that the control means 104 implements the program previously stored in the memory 107.

Hereunder, by using Fig.1 and Fig.2, operations in the radio-corrected timepiece concerned with the present embodiment are detailedly explained.

In the radio-corrected timepiece, when a time instant previously stored in the memory 107 has arrived, or when a user has instructed a time instant correction operation by operating the operation means 106, the control means 104 detects this, thereby commencing the time instant correction operation.

If the time instant correction operation is commenced, when the time code has been first received at a last-time time instant correction operation time and a time instant correction processing has been normally performed, since the control means 104 is operating so as to store the capacity value of the variable capacity diode at that time to the memory 107, it controls so as to make the capacity value stored to the memory 107 on the occasion of the time instant correction processing in this time into an initial value of the variable capacity diode 102 (step S201 in Fig.2).

Under this state, the control means 104 outputs a control signal to the reception means 103, thereby controlling such that the reception means 103 commences a reception operation. By this, the reception means 103 commences the reception operation.

A radio signal containing the time code having an information of a present time instant is received by the antenna 101, and inputted to the reception means 103 through the variable capacity diode 102 (tuning means 102). In the reception means 103, the AGC amplifier 108 amplifies the signal from the variable capacity diode 102, and the filter 109 causes a signal of a predetermined frequency in a signal inputted from the AGC amplifier 108 to pass through, thereby inputting it to the detection circuit 110. The detection circuit 110 detects the signal from the filter 109 to thereby extract the time code, and outputs the extracted time code to the control means 104 and controls a gain of the AGC amplifier.

The control means 104 reads a signal (if it is a normal signal, the time code) from the detection circuit 110 (step S202) and, by judging whether or not the signal from the detection circuit 110 is a digital signal (whether the signal is a signal of a logic "1" or "0"), it judges whether or not the signal from the detection circuit 110 is the time code (step S203).

In a case where there has been judged that the signal from the detection circuit 110 is the digital signal, i.e., in a case where there has been judged to be the time code, the control means 104 determines the capacity value of the variable capacity diode 102 at this time as a capacity (tuning capacity) tuning to the radio signal concerned (step S204). The control means 104 controls the reception means 103 such that the reception means 103 terminates its reception operation after a predetermined time (step S205).

Next, the control circuit 104 judges whether or not a perfect reception of the time code has been successful by the reception operations till the step S205, i.e., whether or not a reception of all information necessary for distinguishing the present time instant contained in the time code has been successful (step S206).

In a case where the control means 104 has judged in the step S206 that the perfect reception of the time code has been successful, after it has corrected a time instant being clocked by a clock means (own clock means) which is self-contained in the control means 104 and clocks a time instant by a present time instant information contained in the received time code (step S207), it stores the capacity value of the variable capacity diode 102 at this time to the memory 107, thereby terminating the time instant correction operation (step S208).

In a case where there has been judged in the step S203 that the signal from the detection circuit 110 is not the digital signal, i.e., in a case where there has been judged not to be the time code, after the control means 104 has altered by a predetermined amount the capacity value of the variable capacity diode 102 by increasing or decreasing by the predetermined amount (step S209), it judges whether or not this has been performed by a predetermined number of times (step S210) and, in a case where it has not been performed by the predetermined number of times, the process returns to the step S202, thereby repeating the processings.

In a case where there has been judged in the step S210 that the above processing has been performed by the predetermined number of times, and in a case where there has been judged in the step S206 that the perfect reception of the time code has not been successful, the control means 104 judges that the tuning frequency greatly deviates, and controls the filter 109 so as to use, instead of the quarts oscillator being used at present among the plural quartz oscillators that the filter 109 has, other quarts oscillator. By this, a frequency (reception frequency) of a signal passing through the filter 109 is switched (step S211). By this, the reception frequency is altered from 40 kHz to 60 kHz for instance.

Under this state, the control means 104 reads the signal (if it is the normal signal, the time code) from the detection circuit 110 (step S212) and, by judging whether or not the signal from the detection circuit 110 is the digital signal (whether the signal is the signal of the logic "1" or "0"), it judges whether or not the signal from the detection circuit 110 is the time code (step S213).

In the case where there has been judged that the signal from the detection circuit 110 is the digital signal, i.e., in the case where there has been judged to be the time code, the control means 104 determines the capacity value of the variable capacity diode 102 at this time as the capacity (tuning capacity) tuning to the radio signal concerned (step S214). The control means 104 controls the reception means 103 such that the reception means 103 terminates its reception operation after the predetermined time (step S215).

Next, the control circuit 104 judges whether or not the perfect reception of the time code has been successful by the reception operations in the step S211 - the step S215, i.e., whether or not the reception of all information necessary for distinguishing the present time instant has been successful (step S216).

In the case where the control means 104 has judged in the step S216 that the perfect reception of the time code has been successful, after it has corrected the time instant being clocked by the clock means (own clock means) which is self-contained in the control means 104 and clocks the time instant by the present time instant information contained in the received time code (step S217), it stores the capacity value of the variable capacity diode 102 at this time to the memory 107, thereby terminating the time instant correction operation (step S218).

On the other hand, in the case where there has been judged in the step S213 that the signal from the detection circuit 110 is not the digital signal, i.e., in the case where there has been judged not to be the time code, after the control means 104 has altered by the predetermined amount the capacity value of the variable capacity diode 102 by increasing or decreasing by the predetermined amount (step S219), it judges whether or not this has been performed by the predetermined number of times (step S220) and, in the case where it has not been performed by the predetermined number of times, the process returns to the step S212, thereby repeating the processings.

In the case where there has been judged in the step S220 that the above process ing has been performed by the predetermined number of times, and in the case where there has been judged in the step S216 that the perfect reception of the time code has not been successful, the control means 104 alters the capacity value of the variable diode 102 to a capacity value, at a last-time reception success time, stored in the memory 107 (step S221) and, after the capacity value concerned has been stored to the memory 107, terminates the processing (step S218).

As mentioned above, according to the embodiment of the present invention, it becomes possible to make so as to be capable of being easily tuned to the standard wave signal, and further it becomes possible to be tuned also to the plural standard wave signals whose frequencies are different.

Further, since it becomes unnecessary to finely adjust the tuning frequency at the assembly time, there becomes such that the assembly work can be performed simply and in the short time, and further the handling becomes easy.

Further, also against the change in the tuning frequency due to temperature and the like, since it is possible to automatically adjust to the tuning state, as a result there is brought about the advantage that the reception sensitivity is improved.

Incidentally, in the above embodiment, although there is adapted such that in the case where there has been judged in the steps S204, S214 that the signal from the detection circuit 110 is the digital signal, i.e., in the case where there has been judged to be the time code, the control means 104 determines the capacity value of the variable capacity diode 102 at this time as the capacity (tuning capacity) tuning to the radio signal concerned, if there is constituted such that, in a case where the digital signal has been continuously received by the predetermined number of times, there is judged that the time code has been received and the capacity value of the variable capacity diode 102 at this time is determined as the capacity (tuning capacity) tuning to the radio signal concerned, it becomes possible to constitute so as to more certainly receive the time code by using the capacity value concerned. By this, it follows that an improvement in the reception sensitivity is substantially contrived.

Further, there may be constituted such that, by the fact that the user instructs a tuning operation by the operation means 106, the control means 104 performs the tuning operation processings except the processing steps S207, S217 while responding to the instruction of the tuning operation by the operation means 106. In this case, the control means 104 does not perform a correction operation of the time instant, but alters the capacity value of the variable capacity diode 102 so as to tune to the radio signal. Further, the control means 104 stores the altered capacity value of the variable capacity diode 102 to the memory 107. For the time instant correction operation in a next time, the capacity value stored to the memory 107 is used as the initial value.

Further, although there has been constituted such that the capacity value of the variable capacity diode 102 is stored to the memory 107, there may be constituted such that an information (i.e., information for specifying the quartz oscillator that the filter uses) for specifying the frequency passing through the filter 109 when the reception has been successful is stored to the memory 107 together with the capacity value of the variable capacity diode 102. In this case, there can be constituted so that the control means 104 releases the tuning by using, in the time instant correction operation in the next time, the capacity value of the variable capacity diode 102, which has been stored to the memory 107, and the passing-through frequency of the filter 109 as the initial values.

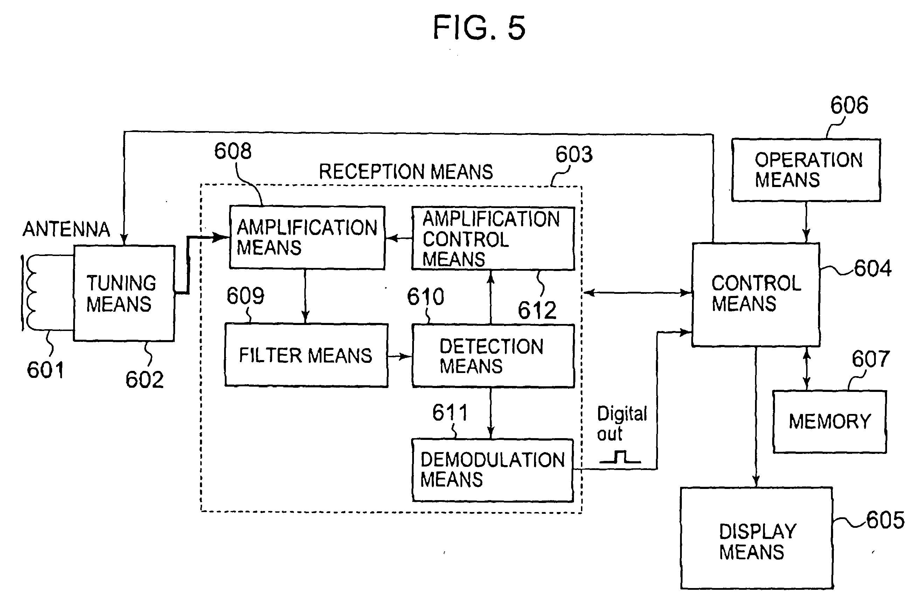

Fig.5 is a block diagram of the radio-corrected timepiece concerned other embodiment of the present invention and, similarly to the above embodiment, is an example of the radio-corrected timepiece in which the time instant correction is performed by using the standard wave signal of Japan shown in Fig.4.

In Fig.5, the radio-corrected timepiece has an antenna 601 constituted by the antenna coil, a tuning means 602 for altering the tuning frequency, a reception means 603, a control means 604 constituted by the central processing unit (CPU) and performing the control and the like of each constitutional element and the whole of the radio-corrected timepiece, a display means 605 constituted by the liquid crystal display and the like and displaying the present time instant and the like, an operation means 606 constituted by the operation switch and the like and for performing the instruction of the time instant correction processing, the instruction of the tuning operation, and the like, and a semiconductor memory 607 as the storage means for storing the program that the control means 604 implements, a capacity value of a variable capacity means (not shown in the drawing) contained in the tuning means, and the like. Incidentally, the control means 604 has also the functions as the time instant correction means and the clock means.

The reception means 603 has an amplification means 608 for amplifying a signal from the tuning means 602, a filter means 609 for causing a signal of a predetermined frequency in an output signal of the amplification means 608 to pass through, a detection means 610 for detecting and outputting an output signal of the filter means 609, a demodulation means 611 for extracting the time code contained in the standard wave signal received by the antenna 601 by demodulating an output signal of the detection means 610 and outputting it to the control means 604, and an amplification control means 612 for controlling a gain of the amplification means 608 in compliance with an output signal level of the detection means 610. The amplification means 608 is an amplification circuit whose gain is variable and, by the amplification control means 612, is controlled so as to become a gain complying with a voltage level (AGC voltage) of a control signal from the amplification control means 612.

Here, in explaining about a corresponding relation between the embodiments of Fig. 1 and Fig. 5, an AGC amplification means constituted by the amplification means 608 and the amplification control means 612 has a function corresponding to the AGC amplifier 108, and the detection means 610 and the demodulation means 611 have a function corresponding to the detection circuit 110. Further, the operation means 606 has a function corresponding to the operation means 106, and the memory 607 has a function corresponding to the memory 107.

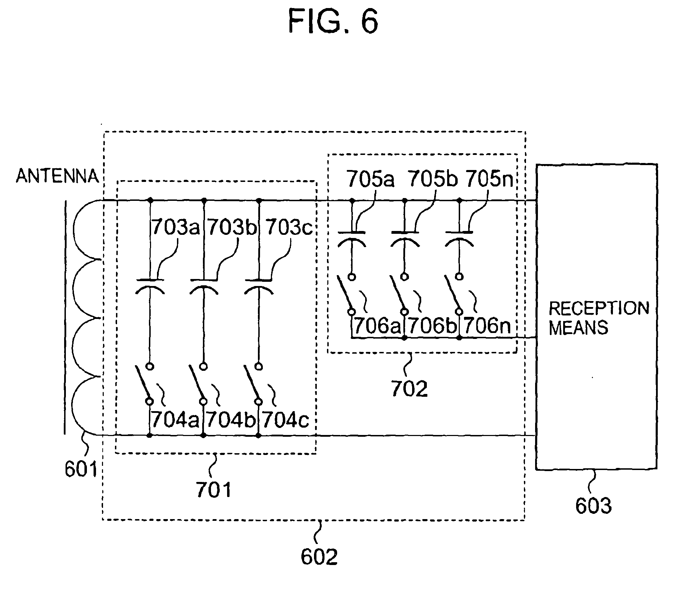

Fig.6 is a circuit diagram showing a constitution of the tuning means 602, and the same reference numeral is applied to the same portion as Fig.5.

In Fig.6, the tuning means 602 possesses a rough adjustment section 701 having plural capacitors 703a - 703c whose capacity values are mutually different, and a fine adjustment section 702 having finely adjusting capacitors 705a- 705n whose capacity values are smaller than the capacitors 703a - 703c in the rough adjustment section 701 and which are for finely adjusting the capacity values of the capacitors 703a - 703 c. The capacitors 703a - 703c are selected to the capacity value (capacity value capable of being approximately tuned) corresponding to the frequency (e.g., 40 kHz, 60 kHz as for Japan, the United States, Britain and 77.5 kHz as for Germany) of the reception signal. The capacity value of the capacitors 705a - 705n is set to a small value in comparison with the capacitors 703a - 703c.

To the capacitors 703a - 703c, 705a - 705n, there are respectively connected open/close switches 704a - 704c, 706a - 706n in series. The rough adjustment section 701 and the fine adjustment section 702 constitute the variable capacity means. On the basis of a signal from an A/D conversion means 613, the control means 604 alters the capacity value of the variable capacity means by combining the capacitors 703a - 703c, 705a - 705n contained in the rough adjustment section 701 and the fine adjustment section 702.

Incidentally, as shown in Fig.6, although there may be constituted such that the capacity value of the variable capacity means is altered by the facts that the plural finely adjusting capacitors 705a - 705n are constituted so as to be contained in the fine adjustment section 702, and that the control means 604 selects a combination of the capacitors 703a - 703c, 705a - 705n contained in the rough adjustment section 701 and the fine adjustment section 701, there may be adapted such that the capacity value of the variable capacity means is altered by the facts that the finely adjusting capacitors 705a - 705n contained in the fine adjustment section 702 are constituted by one or plural variable capacity diode(s), and that the control means 604 selects the capacitors 703a - 703c in the rough adjustment section 701 and controls so as to alter the capacity value of the variable capacity diode. In this case, there may be adapted such that the capacity value of the variable capacity means is altered by the facts that the finely adjusting capacitors contained in the fine adjustment section 702 are constituted by one or plural variable capacity diode(s), and that the control means 604 selects the capacitors in the rough adjustment section 701 and performs a control of the capacity value of the one variable capacity diode or synthesizes the capacity values of the plural variable capacity diodes while controlling them.

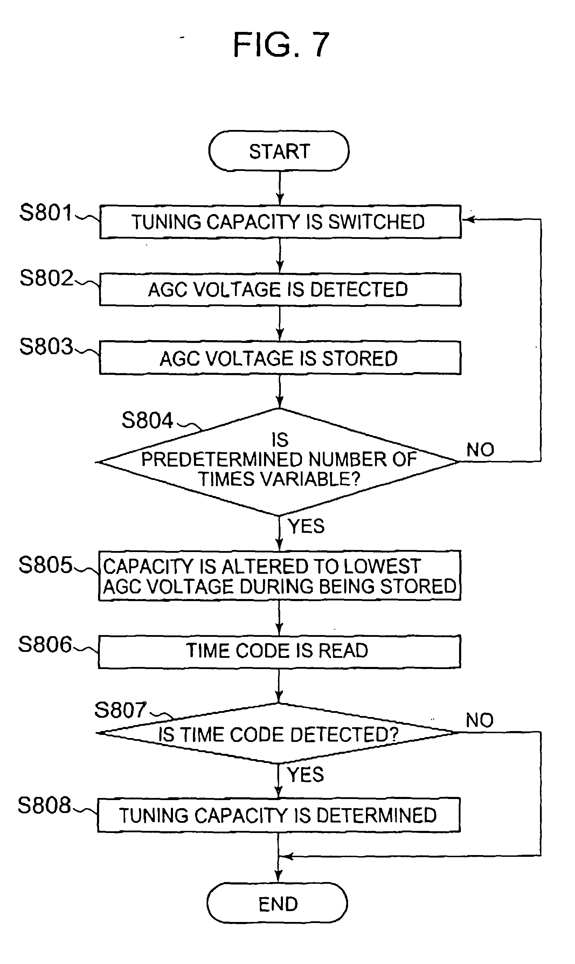

Fig.7 is a flowchart showing processings in the radio-corrected timepiece shown in Fig.5 and Fig. 6, and shows mainly the processings performed by the fact that the control means 604 implements the program previously stored in the memory 607.

Hereunder, by using Fig.5 - Fig.7, operations in the radio-corrected timepiece concerned with the present other embodiment are detailedly explained.

In the radio-corrected timepiece, when the time instant previously stored in the memory 607 has arrived, or when the user has instructed the time instant correction processing by operating the operation means 606, the control means 604 detects this, thereby commencing the time instant correction processing.

If the time instant correction processing is commenced, when the time code has been first received in a tuning point at the last-time time instant correction processing time as mentioned later and the time instant correction processing has been normally performed, since the control means 604 is operating so as to store the capacity value of the variable capacity means of the tuning means 602 at that time to the memory 607, it controls so as to make the capacity value stored to the memory 607 on the occasion of the time instant correction processing in this time into the initial value of the variable capacity means. By this, the capacitors 703a - 703c in the rough adjustment section 701 and the capacitors 705a - 705n in the fine adjustment section 702 are selected with the switches 704a - 704c in the rough adjustment section 701 and the switches 706a - 706c in the fine adjustment section 702 being selectively controlled to an open/close state such that a total capacity value of the rough adjustment section 701 and the fine adjustment section becomes equal to the above capacity value (step S801).

Under this state, the control means 604 outputs the control signal to the reception means 603, thereby controlling such that the reception means 603 commences the reception operation. By this, the reception means 603 commences the reception operation.

The radio signal containing the time code having the information of the present time instant is received by the antenna 601, and inputted to the reception means 603 through the tuning means 602. In the reception means 603, the amplification means 608 simply amplifies the signal from the tuning means 602, and the filter means 609 causes the signal of the predetermined frequency in the signal inputted from the amplification means 608 to pass through, thereby inputting it to the detection means 610.

The detection circuit 610 detects the signal from the filter means 609 to thereby output it to the demodulation means 611, and the demodulation means 611 demodulates the signal from the detection means 610. By this, the demodulation means 611 extracts the time code in the signal outputted from the amplification means 608, and outputs the extracted time code to the control means 604 by the digital signal.

Further, the detection means 610 detects the signal from the filtermeans 609, thereby outputting it to the amplification controlmeans 612. Theamplification controlmeans612supplies the control signal of a voltage level complying with the signal from the detection means 610. By this, the amplification control means 612 controls the amplification means 608 in compliance with a level of the signal from the amplification means 608 such that the gain of the amplification means 608 becomes appropriate.

The control means 604 detects a voltage level of the control signal (AGC signal) supplied from the amplification control means 612 to the amplification means 608 (step S802), and adds and stores the voltage level at this time to the memory 607 (step S803). The control means 604 judges whether or not the above processing has been performed by the predetermined number of times (step S804) and, in the case where it has not been performed by the predetermined number of times, the process returns to the step S801.

The above predetermined number of times is the number of times performed about a predetermined combination of the capacitors contained in the rough adjustment section 701 and the capacitors contained in the fine adjustment section 702.

For example, in Fig.6, a rough adjustment is first performed by selecting one from among the roughly adjusting capacitors 703a - 703c. A fine adjustment of the capacity value is performed by selecting, under this state, the finely adjusting capacitors 705a - 705n one by one in order and being connected in parallel to the selected roughly adjusting capacitor. The above operation is performed about all the roughly adjusting capacitors 703a - 703c. Since it follows that it is performed by n times about each of the roughly adjusting capacitors 703a - 703c, the above predetermined number of times becomes 3n times. Incidentally, there may be constituted such that the plural finely adjusting capacitors 705a - 705n are selected in regard to the roughly adjusting capacitors 703a - 703c.

In a case where there has been judged in the step S804 that the above processing is not performed by the predetermined number of times, after the control means 604 has increased or decreased the capacity value of the variable capacity means by a predetermined amount to thereby alter it by a predetermined amount by altering the combination of the capacitors 603a - 603c constituting the rough adjustment section 701 and the capacitors 705a to 705n constituting the fine adjustment section 702 in the tuning means 602 (step S801), it implements the processing steps S802, S803. By performing the above processing, it follows that plural AGC voltage values are stored to the memory 607.

In a case where there has been judged in the step 5804 that the above processing has been performed by the predetermined number of times, the control means 604 alters the capacity value (value obtained by totaling the capacity values of the capacitors selected from among the capacitors contained in the rough adjustment section 701 and the fine adjustment section) of the variable capacity means to the capacity value of a tuning point with the capacity value when a lowest AGC voltage among the plural AGC voltages stored to the memory 607 being made the tuning point (step S805). That is, the control means 604 detects the voltage level of the signal outputted from the amplification means 608 in plural points while altering the capacity value of the variable capacity means by a predetermined value at a time, and makes a point satisfying a predetermined condition (in the above example, the fact that the AGC voltage is the lowest voltage) among the plural points, in which the voltage level has been detected, into the tuning point.

Incidentally, there may be constituted such that the control means 604 makes a point --in which the voltage level among the plural points, in which the voltage level has been detected, becomes within a predetermined range previously decided-- into the tuning point. In this case, the predetermined range of the voltage level is previously stored to the memory 607, and the control means 604 decides the tuning point while referring to the memory 607.

In a case where the tuning means 602.is being tuned to the standard wave signal, the reception signal of a predetermined level is outputted from the tuning means 602, the AGC voltage at this time becomes a lowest level, and the time code is outputted from the detection means 610. In a case where the tuning means 602 is not being tuned, a level of the signal outputted from the tuning means 602 becomes small, the AGC voltage outputted from the amplification control means 612 at this time becomes a high level, and the time code becomes not outputted from the demodulation means 611. Like this, in the present embodiment, there is made such that, when the AGC voltage value outputted from the amplification control means 612 is the lowest level, the variable capacity means exists in the tuning point.

Under this state, the control means 604 reads a signal (if it is the normal signal, the time code) from the demodulation means 611 through the detection means 610 (step S806) and, by judging whether or not the signal from the demodulation means 611 is the digital signal (whether the signal is the signal of the logic "1" or "0"), it judges whether or not the signal from the demodulation means 611 is the time code (step S807).

In a case where there has been judged that the signal from the demodulation means 611 is the digital signal, i.e., in a case where there has been judged to be the time code, the control means 604 determines the capacity value (i.e., the total capacity value of the capacitors selected from among the capacitors 703a - 703c, 705a - 705n in the rough adjustment section 701 and the fine adjustment section 702) of the variable capacity means at this time as the capacity (tuning capacity) tuning to the radio signal concerned (step S808).

By doing like this, in a case where there has been judged that the time code has been outputted from the reception means 603 in the tuning point, the control means 604 sets the capacity value of the variable capacity means in the tuning point to a capacity value for receiving the time code.

Hereafter, the processings are implemented similarly to the processing steps S205 - S208, thereby performing the time instant correction operation and a preservation operation of the tuning capacity.

On the other hand, in a case where there has been judged in the step S807 that the time code could not been detected, the control means 604 terminates the processing. In this case, there may be adapted so as to perform the processing similarly to the processing step S221 in Fig.2.

As mentioned above, according to other embodiment of the present invention, similarly to the above embodiment, it becomes possible to make so as to be capable of being easily tuned to the standard wave signal, and further it becomes possible to be tuned also to the plural standard wave signals whose frequencies are different.

Further, since it becomes unnecessary to finely adjust the tuning frequency at the assembly time, there becomes such that the assembly work can be performed simply and in the short time, and further the handling becomes easy.

Further, also against the change in the tuning frequency due to temperature and the like, since it is possible to automatically adjust to the tuning state, as a result there is brought about the advantage that the reception sensitivity is improved.

Incidentally, also in the present other embodiment, similarly to the above embodiment, there may be constituted such that, by the fact that the user instructs the tuning operation by the operation means 606, the control means 604 performs the tuning operation processings while responding to the instruction of the tuning operation by the operation means 606. In this case, the control means 604 does not perform the correction operation of the time instant, but alters the capacity value by selecting the combination of the capacitors 703a - 703c, 705a - 705n contained in the rough adjustment section 701 and the fine adjustment section 702 of the variable capacity means so as to be tuned to the radio signal. Further, the control means 604 stores the altered capacity value of the variable capacity means to the memory 607. For the time instant correctionprocessing in the next time, the capacityvalue stored to the memory 607 is used as the initial value.

Further, in the present other embodiment, although there has been constituted such that a combination information of the capacitors 703a - 703c, 705a - 705n for realizing the capacity value of the variable capacity means is stored to the memory 607, there may be constituted such that a signal passing-through characteristic of the f i ltermeans 609 is previously constituted so as to be variable, and an information (e.g., information for specifying the quartz oscillator that the filter means 609 uses) for specifying the frequency passing though the filter means 609 when the reception has been successful is stored together with the capacity value of the variable capacity means 602 to the memory 607. In this case there can be constituted such that, in the time instant correction processing in the next time, the control means 604 commences the tuning processing by using the capacity value of the variable capacity means and a passing-through frequency of the filter means 609, which have been stored to the memory 607.

Further, in the present other embodiment, as the finely adjusting capacitor, there may be used one or plural variable capacity diode (s). In this case, the adjustment of the capacity value can be performed by constituting such that the finely adjusting capacitor performs not only a mere selection, and the control means 604 performs an alteration control of the capacity value.

Further, in the present other embodiment, although there has been constituted so as to control the variable capacity means of the tuning means 602 on the basis of the output signal of the amplification control means 612, there may be constituted so as to alteration-control the capacity value of the variable capacity means on the basis of the signal outputted from the amplification means 608.

Further, in each of the above embodiments, as to the capacitor used in the alteration of the tuning frequency, various modifications are possible such as to so constitute that, not only the variable capacity capacitor, there are utilized capacitors inside an integrated circuit (IC) used, and the capacitors inside the IC are directly switched.

Further, in each of the above embodiments, as a timing for taking the tuning, it can be suitably selected such as performing at every reception time and only at a reception unsuccessful time, or periodically at a predetermined time previously decided, and performing at a radio-corrected timepiece reset time at a product shipping time and at a battery exchanging time.

Further, in each of the above embodiments, as a method of judging whether or not it is the time code, there can be also constituted so as to judge by whether or not an edge (standing-up edge or standing-down edge) of the received digital signal could be accurately, continuously detected by a predetermined number of times.

According to the present invention, it becomes possible to make so as to be capable of being easily tuned to the standard wave signal. Further, it becomes possible to be tuned to the plural standard wave signals whose frequencies are different.

Since it becomes unnecessary to finely adjust the tuning frequency at an assembly time, there becomes such that the assembly work can be performed simply and in a short time, and further a handling becomes easy.

Further, also against a change in the tuning frequency due to temperature and the like, since it is possible to automatically adjust to a tuning state, as a result there is brought about an advantage that the reception sensitivity is improved.

There canbe appliedalso to the radio-corrected timepiece utilized in the state, such as the United States not only Japan, where there is used the standard wave for the time instant correction.

## Claims

1. A radio-corrected timepiece comprising:
an antenna for receiving a radio signal containing a time code having an information of a present time instant;
a tuning means having a variable capacity means and for outputting a signal corresponding to the radio signal received by the antenna;
a reception means extracting the time code from a signal outputted from the tuning means;
a time instant correction means which obtains an information of the present time instant from the time code extracted by the reception means to thereby correct a present time instant being clocked by its own clock means;
a display means for displaying the present time instant being clocked by the clock means; and
a control means which, in a case where there has been judged that the time code is not outputted from the reception means, controls so as to alter a tuning frequency of the tuning means by altering a capacity value of the variable capacity means.

2. A radio-corrected timepiece according to claim 1,
wherein the reception means has a filter means causing plural frequency signals to selectively pass through, and a detection means for extracting the time code having passed through the filter means to thereby output it, and
wherein the control means controls the filter means so as to alter a frequency passing through the filter means in a case where even if the alteration of the capacity value of the variable capacity means is performed by a predetermined number of times there has been judged that time code is not outputted from the reception means.

3. A radio-corrected timepiece according to claim 1, further comprising:
a storage means for storing the capacity value of the variable capacity means when the reception of the time code has been successful, and
wherein the control means terminates a reception operation of the reception means in a case where even if the capacity value of the variable capacity means is altered by a predetermined number of times there has been judged that the time code is not obtained and sets the capacity value of the variable capacity means to the capacity value of the last time in which a reception of the time code stored in the storage means has been successful, thereby terminating a time instant correction processing.

4. A radio-corrected timepiece according to claim 1,
wherein the control means stores the capacity value of the variable capacity means at that time to the storage means in a case where the time code has been received and a time instant correction processing has been performed and on the occasion of the time instant correction processing in a next time, controls the capacity value stored to the storage means so as to make it an initial value of the variable capacity means.

5. A radio-corrected timepiece according to claim 1,
wherein the control means controls the variable capacity means so as to perform a reception operation by using the capacity value of the variable capacity means having been being used when the time code could be continuously received by a predetermined number of times.

6. A radio-corrected timepiece according to claim 1,
wherein the variable capacity means is constituted by a variable capacity diode.

7. A radio-corrected timepiece according to claim 1,
wherein the variable capacitymeans possesses a rough adjustment section having plural roughly adjusting capacitors whose capacity values are mutually different, and a fine adjustment section having finely adjusting capacitors whose capacity values are smaller than the roughly adjusting capacitors, and
the control means alters the capacity value of the variable capacity means by combining the roughly adjusting capacitors and the finely adjusting capacitors.

8. A radio-corrected timepiece according to claim 7,
wherein each of the roughly adjusting capacitors comprises while being selected to the capacity value corresponding to a reception frequency, and
the control means finely adjusts a deviation of the tuning frequency when the roughly adjusting capacitors have been used from the reception frequency by using the finely adjusting capacitors.

9. A radio-corrected timepiece according to claim 7,
wherein the fine adjustment section comprises with the plural finely adjusting capacitors being contained, and the control means alters the capacity value of the variable capacity means by selecting a combination of the capacitors contained in the rough adjustment section and the fine adjustment section.

10. A radio-corrected timepiece according to claim 7,
wherein the finely adjusting capacitor contained in the fine adjustment section comprises while being constituted by a variable capacity diode, and the control means selects the capacitor in the rough adjustment section and alters the capacity value of the variable capacity means by altering the capacity value of the variable capacity diode.

11. A radio-corrected timepiece according to claim 1,
wherein the control means judges that the time code has been received in a case where an edge of a received digital signal could be continuously detected by a predetermined number of times.

12. A radio-corrected timepiece according to claim 1, further comprising:
an operation means for instructing an tuning operation; and
wherein the control means responds to an instruction of the tuning operation by the operation means to thereby alter the capacity value of the variable capacity means so as to be tuned to the radio signal.

13. A radio-corrected timepiece according to claim 12,
wherein the control means alters the capacity value of the variable capacity means so as to be tuned to the radio signal, additionally at a predetermined time previously decided or at a reset time.
